# EUROPEAN PATENT APPLICATION

(11) **EP 4 654 808 A1**
(43) Date of publication of application: **26.11.2025**
(21) Application number: 23917567.2
(22) Date of filing: 20.01.2023
(51) Int. Cl.: H10N 60/01, H10N 60/00, H10N 60/80

(54) **DEVICE AND METHOD FOR PRODUCING DEVICE**

(71) Applicant: FUJITSU LIMITED, Kawasaki-shi, Kanagawa 211-8588 (JP)
(72) Inventor: NAKAMURA, Makoto, Kawasaki-shi, Kanagawa 211-8588 (JP)
(74) Representative: Haseltine Lake Kempner LLP
(86) International application number: PCT/JP2023/001769
(87) International publication number: WO 2024/154354

(57) **Abstract**

A method of manufacturing a device includes a step of forming a conductive film made of a superconducting material on a substrate having a first surface, a second surface opposite to the first surface, and a through hole penetrating between the first surface and the second surface, the conductive film extending from the first surface to the second surface via a side surface of the through hole, a step of patterning the conductive film on the first surface to form a first wiring pattern, a step of patterning the conductive film on the second surface to form a second wiring pattern, and a step of forming a quantum bit element connected to the first wiring pattern.

## Description

### [Technical Field]

The present invention relates to a device and a method of manufacturing a device.

### [Background Art]

There has been known an interposer that is a relay substrate for providing conduction between front and back circuits by means of a through electrode. For example, there has been known that a quantum bit chip is flip-chip mounted on the interposer (for example, Patent Literatures 1 to 3). Further, there has been known a configuration in which a quantum bit and a passive element provided on the front and back surfaces of a substrate are connected by a through electrode (for example, Patent Literature 4).

### [Citation List]

### [Patent Literature]

Patent Literature 1: International Publication Pamphlet No. WO2021/245949
Patent Literature 2: International Publication Pamphlet No. WO2018/212041
Patent Literature 3: U.S. Patent application Publication No. 2022/0199507
Patent Literature 4: U.S. Patent application Publication No. 2020/0343434

### [Summary of Invention]

### [Technical Problem]

When a first wiring pattern formed on a first surface of a substrate, a second wiring pattern formed on a second surface opposite to the first surface, and a through electrode formed in a through hole between the first surface and the second surface are formed in separate steps, the number of manufacturing steps increases.

In one aspect, the object of the present disclosure is to reduce the manufacturing steps.

### [Solution to Problem]

In one aspect, there is provided a method for manufacturing a device including a step of forming a conductive film made of a superconducting material on a substrate having a first surface, a second surface opposite to the first surface, and a through hole penetrating between the first surface and the second surface, the conductive film extending from the first surface to the second surface via a side surface of the through hole, a step of patterning the conductive film on the first surface to form a first wiring pattern, a step of patterning the conductive film on the second surface to form a second wiring pattern, and a step of forming a quantum bit element connected to the first wiring pattern.

In one aspect, there is provided a device including a substrate having a first surface, a second surface opposite to the first surface, and a through hole penetrating between the first surface and the second surface, a through electrode made of a superconducting material extending from the first surface to the second surface via a side surface of the through hole, a first wiring pattern provided on the first surface and formed of the same material as the through electrode, a second wiring pattern provided on the second surface and formed of the same material as the through electrode, and a quantum bit element connected to the first wiring pattern.

### [Advantageous Effects of Invention]

As one aspect, the number of manufacturing steps can be reduced.

### [Brief Description of Drawings]

[FIG. 1] FIG. 1 is a cross-sectional view of a device according to a first embodiment.
[FIG. 2] FIGs. 2(a) to 2(c) are cross-sectional views (Part 1) illustrating a method of manufacturing the device according to the first embodiment.
[FIG. 3] FIGs. 3(a) to 3(c) are cross-sectional views (Part 2) illustrating a method of manufacturing the device according to the first embodiment.
[FIG. 4] FIGs. 4(a) to 4(c) are cross-sectional views (Part 3) illustrating a method of manufacturing the device according to the first embodiment.
[FIG. 5] FIGs. 5(a) to 5(c) are cross-sectional views (Part 4) illustrating a method of manufacturing the device according to the first embodiment.
[FIG. 6] FIG. 6 is a cross-sectional view illustrating an example of the film formation of of a conductive film in the first embodiment.
[FIG. 7] FIGs. 7(a) and 7(b) are cross-sectional views illustrating a method of manufacturing a device according to a second embodiment.
[FIG. 8] FIGs. 8(a) to 8(c) are cross-sectional views (Part 1) illustrating a method of manufacturing a device according to a third embodiment.
[FIG. 9] FIGs. 9(a) to 9(c) are cross-sectional views (Part 2) illustrating a method of manufacturing the device according to the third embodiment.
[FIG. 10] FIG. 10 is a cross-sectional view of a device according to a fourth embodiment.
[FIG. 11] FIG. 11(a) is a plan view of a quantum bit element according to the fourth embodiment, and FIG. 11(b) is a cross-sectional view taken along a line A-A in FIG. 11(a).
[FIG. 12] FIGs. 12(a) to 12(c) are cross-sectional views (Part 1) illustrating a method of manufacturing a device according to the fourth embodiment.
[FIG. 13] FIGs. 13(a) to 13(c) are cross-sectional views (Part 2) illustrating a method of manufacturing the device according to the fourth embodiment.
[FIG. 14] FIGs. 14(a) to 14(c) are first cross-sectional views (Part 1) illustrating a method of manufacturing a quantum bit element and a seventh wiring pattern according to the fourth embodiment.
[FIG. 15] FIGs. 15(a) to 15(c) are cross-sectional views (Part 2) illustrating a method of manufacturing the quantum bit element and the seventh wiring pattern according to the fourth embodiment.
[FIG. 16] FIGs. 16(a) to 16(c) are cross-sectional views (Part 1) illustrating a method of manufacturing a device according to a comparative example.
[FIG. 17] FIGs. 17(a) to 17(c) are cross-sectional views (Part 2) illustrating a method of manufacturing the device according to the comparative example.
[FIG. 18] FIG. 18 is a cross-sectional view of a case where a plurality of wiring layers are laminated closer to the substrate than the quantum bit element.
[FIG. 19] FIG. 19 is a cross-sectional view showing a method of manufacturing a device according to a fifth embodiment.

### [Description of Embodiments]

Hereinafter, embodiments of the present disclosure will be described with reference to the drawings.

### [First Embodiment]

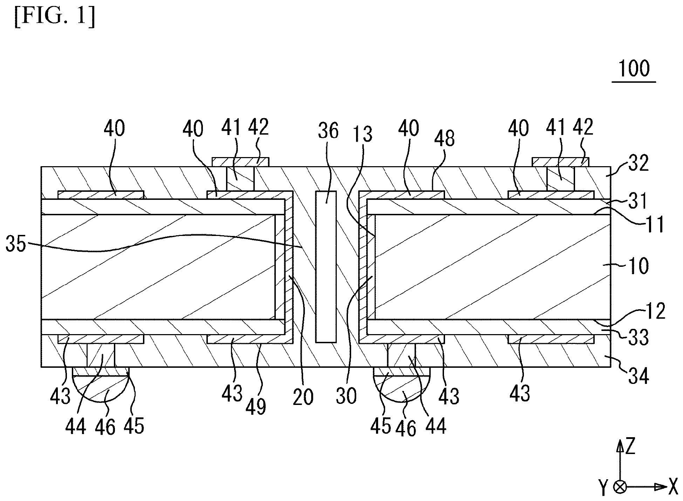

FIG. 1 is a cross-sectional view of a device according to a first embodiment. The first embodiment indicates an example in which a device 100 is an interposer. Directions parallel to a first surface 11 of a substrate 10 and perpendicular to each other are defined as an X-axis and a Y-axis, and the thickness direction of the substrate 10 is defined as a Z-axis. As illustrated in FIG. 1, in the device 100 according to the first embodiment, a through hole 13 passing through between the first surface 11 and a second surface 12 is formed in the substrate 10 having the first surface 11 and the second surface 12 opposite to the first surface 11. The substrate 10 is, for example, a silicon substrate, a glass substrate, or a quartz substrate. The through hole 13 has a diameter of, for example, about 5 µm to 15 µm and a depth of about 100 µm to 300 µm.

A through electrode 20 is provided in the through hole 13. The through electrode 20 has a cylindrical shape extending from on the first surface 11 to on the second surface 12 along the side surface of the through hole 13. An insulating film 30 is provided between the side surface of the through hole 13 and the through electrode 20. The through electrode 20 is formed of, for example, titanium nitride, and has a thickness of, for example, about 50 nm to 150 nm. The insulating film 30 is formed of, for example, silicon oxide and has a thickness of, for example, 50 nm to 150 nm.

One or a plurality of first wiring patterns 40 are provided on the first surface 11 of the substrate 10 via an insulating film 31. At least a part of the one or the plurality of first wiring patterns 40 is connected to the through electrode 20. The first wiring patterns 40 are formed of the same material as the through electrode 20 (for example, titanium nitride) and has the same thickness as the through electrode 20. The one or the plurality of first wiring patterns 40 may include dummy wirings through which no current flows and which are at ground potential during operation of the chips mounted on the first surface 11 and the second surface 12 of the substrate 10. The insulating film 31 is formed of, for example, silicon oxide and has a thickness of, for example, about 50 nm to 150 nm. Here, the fact that the thicknesses of the first wiring patterns 40 are the same as the thickness of the through electrode 20 is not limited to a case where the thicknesses are completely the same as each other, and a difference to the extent of a manufacturing error is allowed. For example, the thicknesses of the first wiring patterns 40 are 90% or more and 110% or less of the thickness of the through electrode 20, and may be 95% or more and 105% or less of the thickness of the through electrode 20.

An insulating film 32 covering the one or the plurality of first wiring patterns 40 is provided on the first surface 11 of the substrate 10. Through wirings 41 are provided which are embedded into openings provided in the insulating film 32 and connected to the first wiring patterns 40. First terminal electrodes 42 connected to the through wirings 41 and serving as terminals for external connection are provided on the insulating film 32. The insulating film 32 is formed of, for example, silicon oxide, and has a thickness of, for example, 100 nm to 300 nm. The first terminal electrodes 42 are formed of a high-melting-point metal material such as vanadium, molybdenum, hafnium, or tantalum. The through wirings 41 may be formed of the same material as the first terminal electrodes 42 or may be formed of a different material from the first terminal electrodes 42.

One or a plurality of second wiring patterns 43 are provided on the second surface 12 of the substrate 10 via an insulating film 33. At least a part of the one or the plurality of second wiring patterns 43 is connected to the through electrode 20. The second wiring patterns 43 are formed of the same material as the through electrode 20 (for example, titanium nitride) and has the same thickness as the through electrode 20. The one or the plurality of second wiring patterns 43 may include dummy wirings through which no current flows and which are at ground potential during the operation of the chips mounted on the first surface 11 and the second surface 12 of the substrate 10. The insulating film 33 is formed of, for example, silicon oxide, and has a thickness of, for example, about 50 nm to 150 nm. Here, the fact that the thickness of the second wiring pattern 43 is the same as the thickness of the through electrode 20 is not limited to a case where the thicknesses are completely the same as each other, and a difference to the extent of a manufacturing error is allowed. For example, the thickness of the second wiring pattern 43 is 90% or more and 110% or less of the thickness of the through electrode 20, and may be 95% or more and 105% or less of the thickness of the through electrode 20.

An insulating film 34 covering the one or the plurality of second wiring patterns 43 is provided on the second surface 12 of the substrate 10. Through wirings 44 are provided which are embedded into openings provided in the insulating film 34 and connected to the second wiring patterns 43. Second terminal electrodes 45 connected to the through wirings 44 and serving as terminals for external connection are provided on the insulating film 34. Bump electrodes 46 are provided on the surfaces of the second terminal electrodes 45. The insulating film 34 is formed of, for example, silicon oxide, and has a thickness of, for example, 100 nm to 300 nm. The second terminal electrodes 45 are formed of a high-melting-point metal material, as in the case of the first terminal electrodes 42. The through wirings 44 may be formed of the same material as the second terminal electrodes 45 or may be formed of a different material from the second terminal electrodes 45. The bump electrode 46 is formed of, for example, indium, gallium, or solder.

An insulating film 35 covering the surface of the through electrode 20 is provided in the through hole 13. A cavity 36 is formed in the through hole 13 at a position closer to the center than the insulating film 35. By covering the through electrode 20 with the insulating film 35, the through electrode 20 is protected and the occurrence of unintended conduction is suppressed. The insulating film 35 is formed of, for example, silicon oxide and has a thickness of, for example, about 25 nm to 75 nm. The through hole 13 may be filled with the insulating film 35 without forming the cavity 36 at a position closer to the center than the through electrode 20, or may be filled with the insulating film 35 and another film made of a different material from the insulating film 35.

The total area of the surface 48 of the one or the plurality of first wiring patterns 40 on the side opposite to the substrate 10 is the same as the total area of the surface 49 of the one or the plurality of second wiring patterns 43 on the side opposite to the substrate 10. The fact that the areas are the same is not limited to a case where the areas are completely the same as each other, but a difference to the extent of a manufacturing error is allowed. For example, the total area of the surfaces 48 of the one or the plurality of first wiring patterns 40 is 90% or more and 110% or less the total area of the surfaces 49 of the one or the plurality of second wiring patterns 43, and may be 95% or more and 105% or less of the total area of the surfaces 49 of the one or the plurality of second wiring patterns 43.

When the quantum bit chip is mounted on the device 100, it is preferable that the electrodes and the wirings are formed of a superconducting material exhibiting superconductivity at a cryogenic temperature (for example, 10 Kelvin or less). That is, the first wiring patterns 40, the second wiring patterns 43, the first terminal electrodes 42, the second terminal electrodes 45, the through wirings 41 and 44, and the bump electrodes 46 are preferably formed of the superconducting material. Examples of the superconducting material include aluminum, titanium, vanadium, zinc, gallium, zirconium, niobium, molybdenum, technetium, cadmium, indium, tin, hafnium, tantalum, niobium nitride, and titanium nitride. When a chip other than the quantum bit chip is mounted on the device 100, the electrodes and the wirings may be formed of copper, tungsten, or the like in addition to the above-described materials.

### [Manufacturing Method]

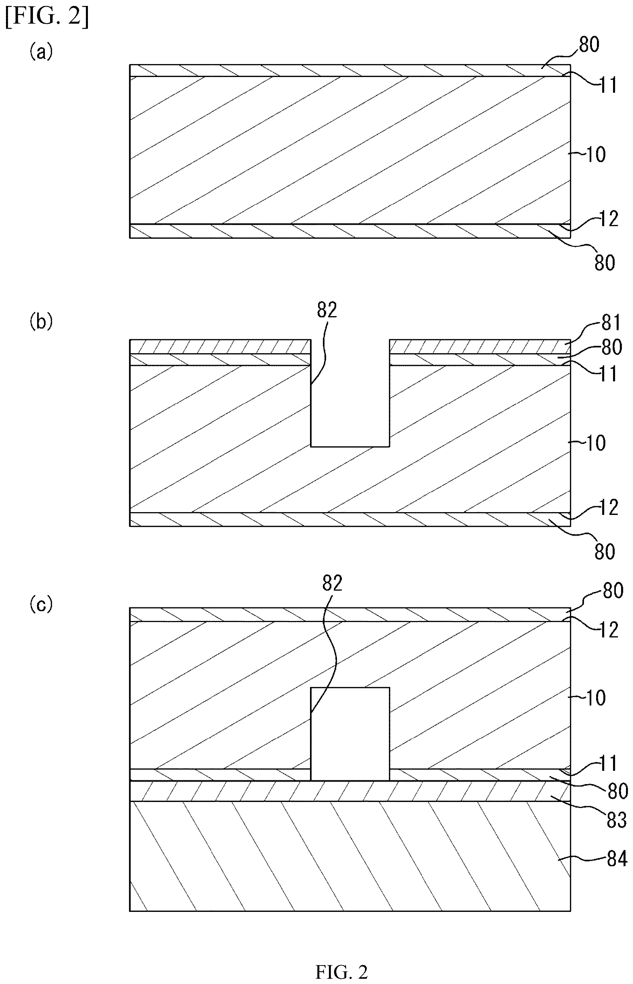

FIGs. 2(a) to 5(c) are cross-sectional views illustrating a method of manufacturing a device according to the first embodiment. As illustrated in FIG. 2(a), after the substrate 10 which is a silicon substrate is cleaned, the substrate 10 is heated in an oxidizing atmosphere to form a thermal oxide film 80 which is a silicon oxide film on the first surface 11 and the second surface 12 of the substrate 10. The thickness of the thermal oxide film 80 is 100 nm as an example.

As illustrated in FIG. 2(b), a resist film 81 is formed by applying a resist onto the thermal oxide film 80 formed on the first surface 11 of the substrate 10. The resist film 81 is exposed and developed to form an opening in the resist film 81. A hard mask layer may be formed between the resist film 81 and the thermal oxide film 80. Using the resist film 81 as a mask, a recess 82 is formed in the substrate 10. The recess 82 is formed by using, for example, a Bosch process. The recess 82 corresponds to the through hole 13 in FIG. 1, and has a diameter of, for example, 10 µm and a depth of, for example, 200 µm.

As illustrated in FIG. 2(c), after the resist film 81 is removed, the substrate 10 is turned upside down, and the thermal oxide film 80 is bonded to a supporting substrate 84 by an adhesive 83. The supporting substrate 84 is, for example, a silicon substrate.

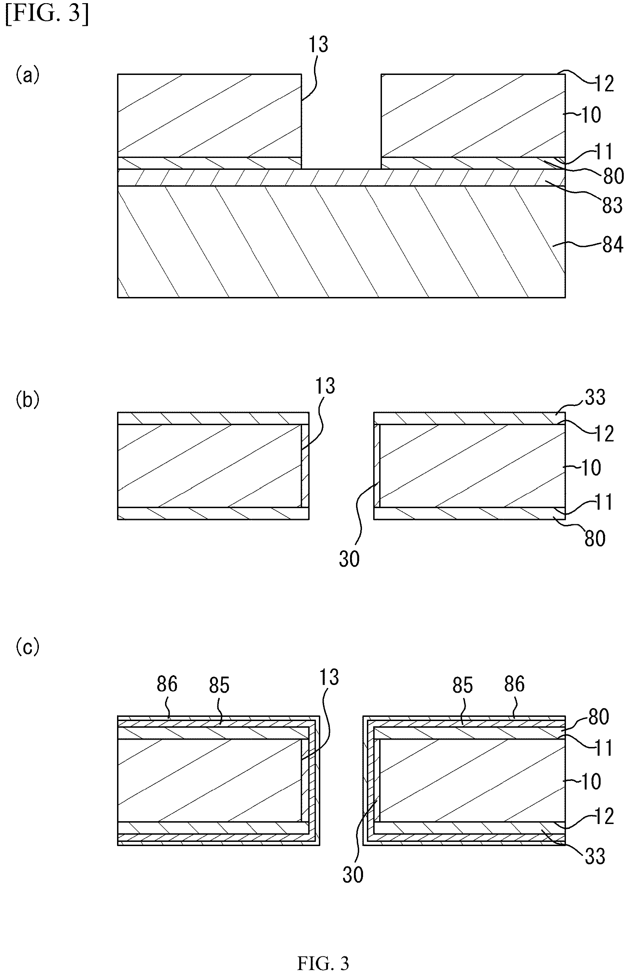

As illustrated in FIG. 3(a), the substrate 10 is thinned by grinding and polishing (for example, chemical mechanical polishing (CMP)) from the second surface 12 side to expose the recess 82. As a result, the through hole 13 is formed in the substrate 10, the through hole 13 passing through the substrate 10 between the first surface 11 and the second surface 12.

As illustrated in FIG. 3(b), after the supporting substrate 84 is peeled off, the substrate 10 is heated in an oxidizing atmosphere to form the insulating film 33 as a silicon oxide film on the second surface 12 of the substrate 10, and the insulating film 30 as a silicon oxide film is formed on the side surface of the through hole 13. The thicknesses of the insulating films 30 and 33 are 100 nm as an example. Note that the insulating films 30 and 33 may be formed by a chemical vapor deposition (CVD) method. In the case of using the adhesive 83 whose adhesive strength is reduced by, for example, ultraviolet rays irradiation, the supporting substrate 84 is peeled off by irradiating the adhesive 83 with ultraviolet rays.

As illustrated in FIG. 3(c), the substrate 10 is turned upside down, and a conductive film 85 extending from on the first surface 11 of the substrate 10 to on the second surface 12 via the side surface of the through hole 13 is formed by a single film formation process by, for example, an atomic layer deposition (ALD) method. For example, the conductive film 85 made of titanium nitride is formed by the ALD method using Ti[N(CH₃)₂]₄ gas and NH₃ gas. The thickness of the conductive film 85 is, for example, 100 nm. N₂H₄ gas may be used instead of NH₃ gas. Thereafter, an insulating film 86 made of a silicon oxide film covering the surface of the conductive film 85 is formed by, for example, the ALD method. The thickness of the insulating film 86 is 50 nm as an example. The insulating film 86 is formed to suppress deterioration of the conductive film 85 due to exposure of the conductive film 85 and to suppress occurrence of unintended conduction in the conductive film 85.

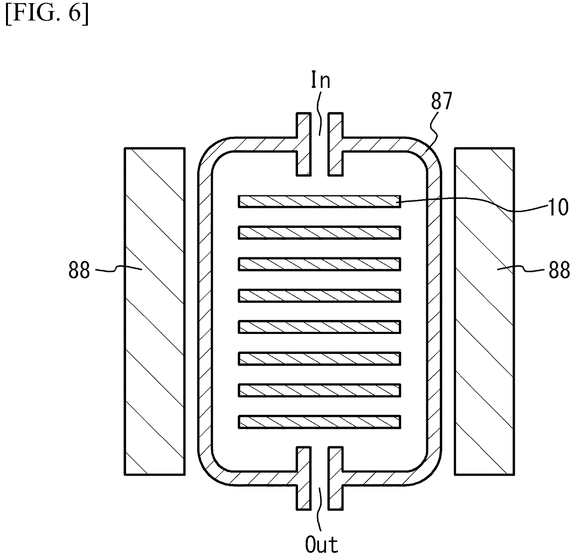

FIG. 6 is a cross-sectional view illustrating an example of the film formation of the conductive film in the first embodiment. As illustrated in FIG. 6, the substrates 10 are placed on a supporter (not illustrated) such as a quartz basket and are arranged in a film formation chamber 87 of an ALD apparatus. Thereafter, Ti[N(CH₃)₂]₄ gas and NH₃ gas are introduced into the film formation chamber 87 from an inlet In toward an outlet Out, and the conductive film 85 is formed on the substrate 10. As a result, as illustrated in FIG. 3(c), the conductive film 85 having a uniform thickness is formed not only on the first surface 11 of the substrate 10 but also on the second surface 12 and the side surfaces of the through holes 13. FIG. 6 illustrates an example of the case where the ALD apparatus is a hot wall ALD apparatus having heating units 88 provided near the film formation chamber 87. Although the case of a batch type is illustrated as an example, the case of a single wafer type may be used.

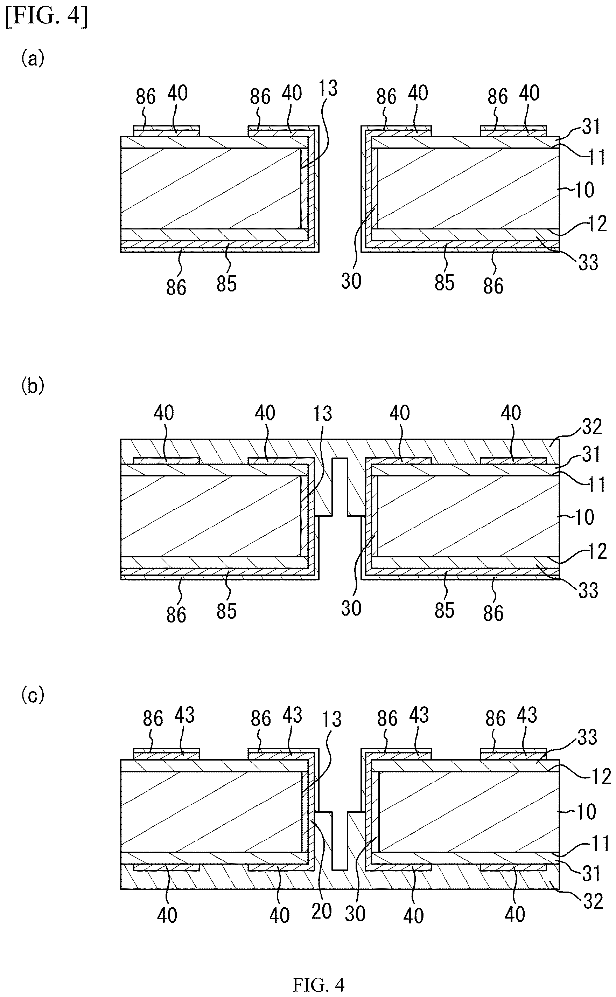

As illustrated in FIG. 4(a), an opening is formed in the insulating film 86 formed on the first surface 11 of the substrate 10 by reactive ion etching (RIE) using, for example, a fluorine-based gas. Thereafter, the conductive film 85 formed on the first surface 11 of the substrate 10 is patterned by the RIE using, for example, a chlorine-based gas, thereby forming the one or the plurality of first wiring patterns 40. The first wiring patterns 40 are formed on the first surface 11 of the substrate 10 through the insulating film 31 made of the thermal oxide film 80.

As illustrated in FIG. 4(b), an insulating film made of a silicon oxide film is formed on the first surface 11 of the substrate 10 by, for example, a CVD method, and the insulating film 32 covering the one or the plurality of first wiring patterns 40 is formed on the insulating film 31 together with the insulating film 86. The thickness of the insulating film 32 is 200 nm as an example.

As illustrated in FIG. 4(c), the substrate 10 is turned upside down, and an opening is formed in the insulating film 86 formed on the second surface 12 of the substrate 10 by the RIE using, for example, a fluorine-based gas. Thereafter, the conductive film 85 formed on the second surface 12 of the substrate 10 is patterned by the RIE using, for example, a chlorine-based gas, thereby forming the one or the plurality of second wiring patterns 43. The second wiring patterns 43 are formed on the second surface 12 of the substrate 10 via the insulating film 33. The cylindrical through electrode 20 made of the conductive film 85 is formed on the side surface of the through hole 13 so as to be connected to the first wiring patterns 40 and the second wiring patterns 43.

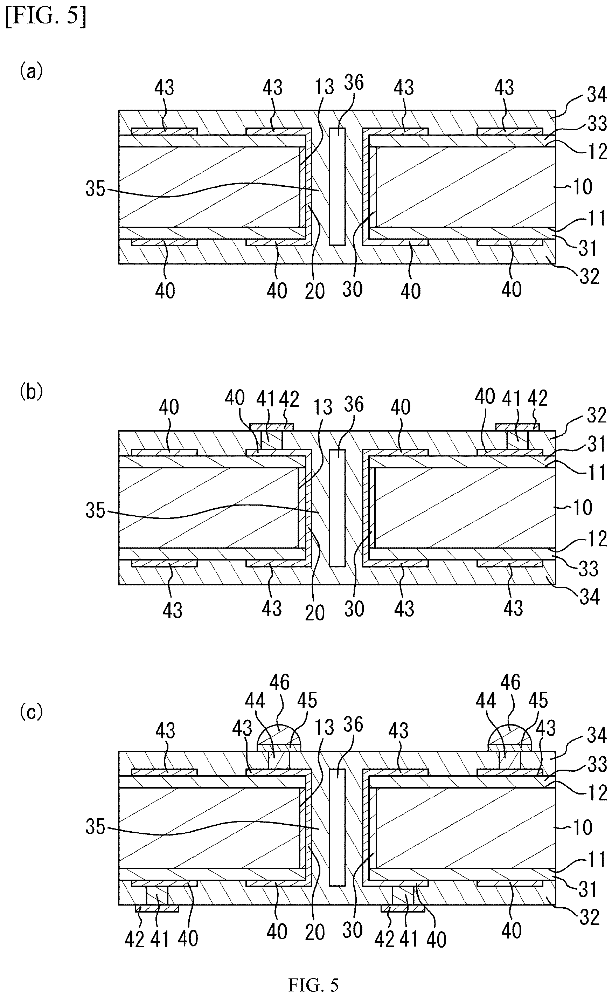

As illustrated in FIG. 5(a), an insulating film made of a silicon oxide film is formed on the second surface 12 of the substrate 10 by, for example, the CVD method, and the insulating film 34 covering the one or the plurality of second wiring patterns 43 is formed on the insulating film 33 together with the insulating film 86. The thickness of the insulating film 34 is 200 nm as an example. The insulating film 35 covering the surface of the through electrode 20 is formed at a position closer to the center than the through electrode 20 in the through hole 13. The cavity 36 is formed at a position closer to the center than the insulating film 35 in the through hole 13.

As illustrated in FIG. 5(b), the substrate 10 is turned upside down, and openings for exposing the first wiring patterns 40 are formed in the insulating film 32 by the RIE using, for example, a fluorine-based gas. Thereafter, the through wirings 41 are formed by, for example, a sputtering method, so as to be embedded into the openings formed in the insulating film 32 and be connected to the first wiring patterns 40. The first terminal electrodes 42 connected to the through wirings 41 are formed on the insulating film 32 by, for example, the sputtering method and an etching method. The through wirings 41 and the first terminal electrodes 42 are not limited to be formed in separate steps, but may be formed simultaneously in the same step.

As illustrated in FIG. 5(c), after the substrate 10 is turned upside down, the through wirings 44 connected to the second wiring patterns 43 are formed in the insulating film 34 by the same method as the formation method of the through wirings 41 and the first terminal electrodes 42, and the second terminal electrodes 45 connected to the through wirings 44 are formed. The through wirings 44 and the second terminal electrodes 45 are not limited to be formed in separate steps, but may be formed simultaneously in the same step. Thereafter, the bump electrodes 46 are formed on the surfaces of the second terminal electrodes 45. As a result, the device 100 according to the first embodiment is formed.

In FIGs. 5(b) and 5(c), the case where the through wirings 44 and the second terminal electrodes 45 are formed after the through wirings 41 and the first terminal electrodes 42 are formed is illustrated as an example, but the through wirings 44, the second terminal electrodes 45, the through wirings 41 and the first terminal electrodes 42 may be formed in the reverse order. The bump electrodes 46 may be formed on the first terminal electrodes 42 without being formed on the second terminal electrodes 45, may be formed on both the first terminal electrodes 42 and the second terminal electrodes 45, or need not be formed on both the first terminal electrodes 42 and the second terminal electrodes 45.

As described above, according to the first embodiment, as illustrated in FIG. 3(c), the conductive film 85 is formed so as to extend from on the first surface 11 of the substrate 10 to on the second surface 12 via the side surface of the through hole 13. As illustrated in FIG. 4(a), the conductive film 85 formed on the first surface 11 of the substrate 10 is patterned to form the one or the plurality of first wiring patterns 40. As illustrated in FIG. 4(c), the conductive film 85 formed on the second surface 12 of the substrate 10 is patterned to form the one or the plurality of second wiring patterns 43. The through electrode 20 made of the conductive film 85 extending from on the first surface 11 to on the second surface 12 through the side surface of the through hole 13 is formed. Therefore, in the first embodiment, the one or the plurality of first wiring patterns 40 formed on the first surface 11 and the one or the plurality of second wiring patterns 43 formed on the second surface 12 are formed of the same material as the through electrode 20 and have the same thickness as the through electrode 20. This can reduce the number of manufacturing steps compared to the case where the first wiring patterns 40, the second wiring patterns 43, and the through electrode 20 are formed by separate formation films. Therefore, energy and materials used in the manufacturing process can be reduced. The fact that the thicknesses are the same is not limited to a case where the thicknesses are completely the same as each other, but a difference to the extent of a manufacturing error is allowed. For example, the thicknesses of the first wiring patterns 40 and the second wiring patterns 43 are 90% or more and 110% or less of the thickness of the through electrode 20, and may be 95% or more and 105% or less of the thickness of the through electrode 20.

In the first embodiment, the conductive film 85 is formed by the ALD method as illustrated in FIG. 3(c). Thus, even when the aspect ratio of the through hole 13 is large, the conductive film 85 having the same thickness can be formed on the first surface 11, the second surface 12, and the side surface of the through hole 13 of the substrate 10.

In addition, in the first embodiment, as illustrated in FIG. 1, the first wiring patterns 40 and the second wiring patterns 43 are formed so that the total area of the surfaces 48 of the one or the plurality of first wiring patterns 40 on the side opposite to the substrate 10 is the same as the total area of the surfaces 49 of the one or the plurality of second wiring patterns 43 on the side opposite to the substrate 10. This can reduce the warpage of the substrate 10. Therefore, the bonding reliability when the chip is flip-chip mounted on the substrate 10 can be improved, and the yield in the formation of the first terminal electrodes 42 and the second terminal electrodes 45 can be improved. The fact that the areas are the same is not limited to a case where the areas are completely the same as each other, but a difference to the extent of a manufacturing error is allowed. For example, the total area of the surfaces 48 of the one or the plurality of first wiring patterns 40 is 90% or more and 110% or less of the total area of the surfaces 49 of the one or the plurality of second wiring patterns 43, and may be 95% or more and 105% or less of the total area of the surfaces 49 of the one or the plurality of second wiring patterns 43.

In addition, in the first embodiment, as illustrated in FIG. 5(b), the first terminal electrodes 42 for external connection connected to the one or the plurality of first wiring patterns 40 are formed on the first surface 11 of the substrate 10. As illustrated in FIG. 5(c), the second terminal electrodes 45 for external connection connected to the one or the plurality of second wiring patterns 43 is formed on the second surface 12 of the substrate 10. This allows the device 100 of the first embodiment to be used as the interposer.

In the first embodiment, the conductive film 85 is formed of titanium nitride. By forming the conductive film 85 with the superconducting material in this manner, the device 100 can be used as the interposer on which a quantum bit chip is mounted.

### [Second Embodiment]

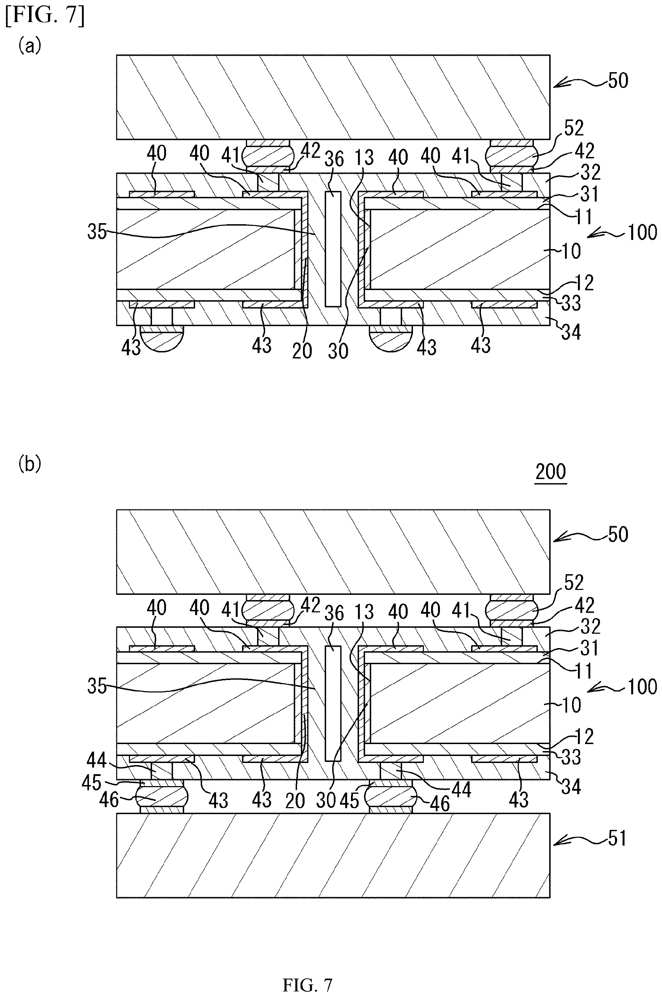

FIGs. 7(a) and 7(b) are cross-sectional views illustrating a method of manufacturing a device according to a second embodiment. As illustrated in FIG. 7(a), a quantum bit chip 50 is flip-chip mounted on the first surface 11 of the substrate 10 constituting the device 100. The quantum bit chip 50 is bonded to the first terminal electrodes 42 by bump electrodes 52. Although not illustrated, a quantum bit element is formed in the quantum bit chip 50. As illustrated in FIG. 7(b), a circuit chip 51 is flip-chip mounted on the second surface 12 of the substrate 10. The circuit chip 51 is bonded to the second terminal electrodes 45 by bump electrodes 46. Although not illustrated, an active element such as a CMOS element and/or a passive element such as an inductor or a capacitor are formed in the circuit chip 51. Thus, a device 200 according to the second embodiment is formed.

According to the second embodiment, as illustrated in FIG. 7(a), the quantum bit chip 50 is mounted on the first surface 11 of the substrate 10. As illustrated in FIG. 7(b), the circuit chip 51 is mounted on the second surface 12 of the substrate 10. As a result, the device 200 in which the quantum bit chip 50 and the circuit chip 51 are mounted on the substrate 10 is obtained. In addition, when the total area of the surfaces 48 of the one or the plurality of first wiring patterns 40 and the total area of the surfaces 49 of the one or the plurality of second wiring patterns 43 are the same as each other, the warpage of the substrate 10 is reduced, and therefore the bonding reliability between the substrate 10, and the quantum bit chip 50 and the circuit chip 51 is improved.

In the second embodiment, the circuit chip 51 may be mounted on the first surface 11 of the substrate 10, and the quantum bit chip 50 may be mounted on the second surface 12.

### [Third Embodiment]

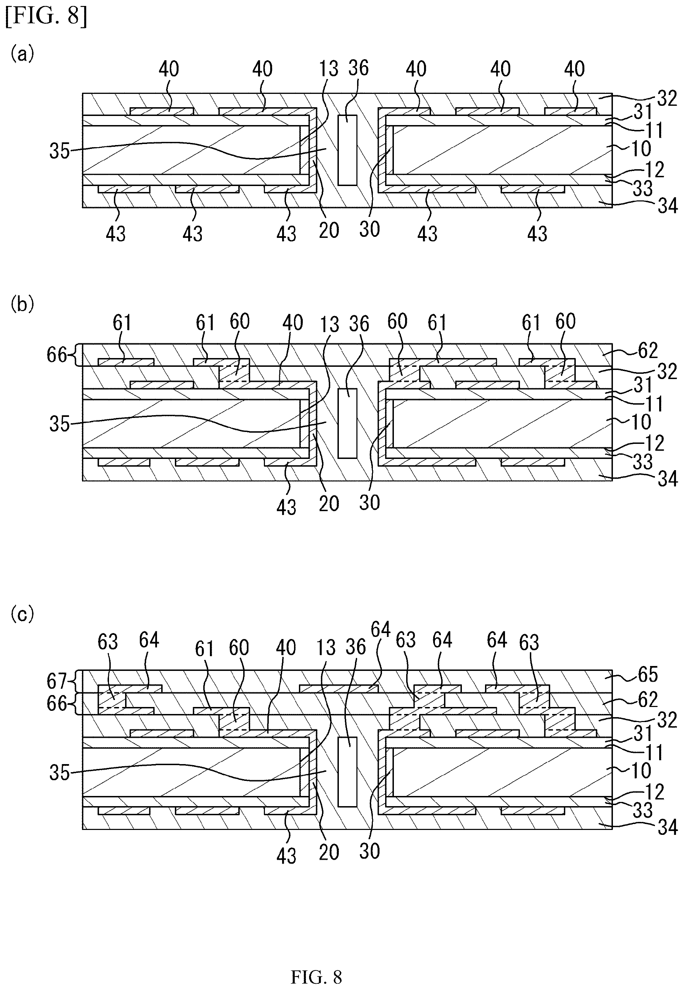

FIGs. 8(a) to 9(c) are cross-sectional views illustrating a method of manufacturing a device according to a third embodiment. As illustrated in FIG. 8(a), the same processes as that illustrated in FIGs. 2(a) to 5(a) of the first embodiment are performed to obtain FIG. 8(a).

As illustrated in FIG. 8(b), openings through which the first wiring patterns 40 are exposed are formed in the insulating film 32 by the RIE using, for example, a fluorine-based gas, and through wirings 60 are formed by, for example, the sputtering method so as to fill the openings. Thereafter, a conductive film is formed on the first surface 11 of the substrate 10 by, for example, the sputtering method, and then the conductive film is patterned by, for example, RIE using a chlorine-based gas to form one or a plurality of third wiring patterns 61. The third wiring pattern 61 is formed of, for example, titanium nitride. Next, an insulating film 62 which is a silicon oxide film is formed on the first surface 11 of the substrate 10 by, for example, the CVD method. The insulating film 62 is formed on the insulating film 32 so as to cover the one or the plurality of third wiring patterns 61. Thus, a wiring layer 66 including the one or the plurality of third wiring patterns 61 and the insulating film 62 is formed.

As illustrated in FIG. 8(c), openings through which the third wiring patterns 61 are exposed are formed in the insulating film 62, and through wirings 63 are formed so as to fill the openings. One or a plurality of fourth wiring patterns 64 connected to the through wirings 63 are formed on the insulating film 62. The fourth wiring pattern 64 is formed of, for example, titanium nitride. An insulating film 65 is formed on the insulating film 62 so as to cover the one or the plurality of the fourth wiring patterns 64. Thus, a wiring layer 67 including the one or the plurality of fourth wiring patterns 64 and the insulating film 65 is formed.

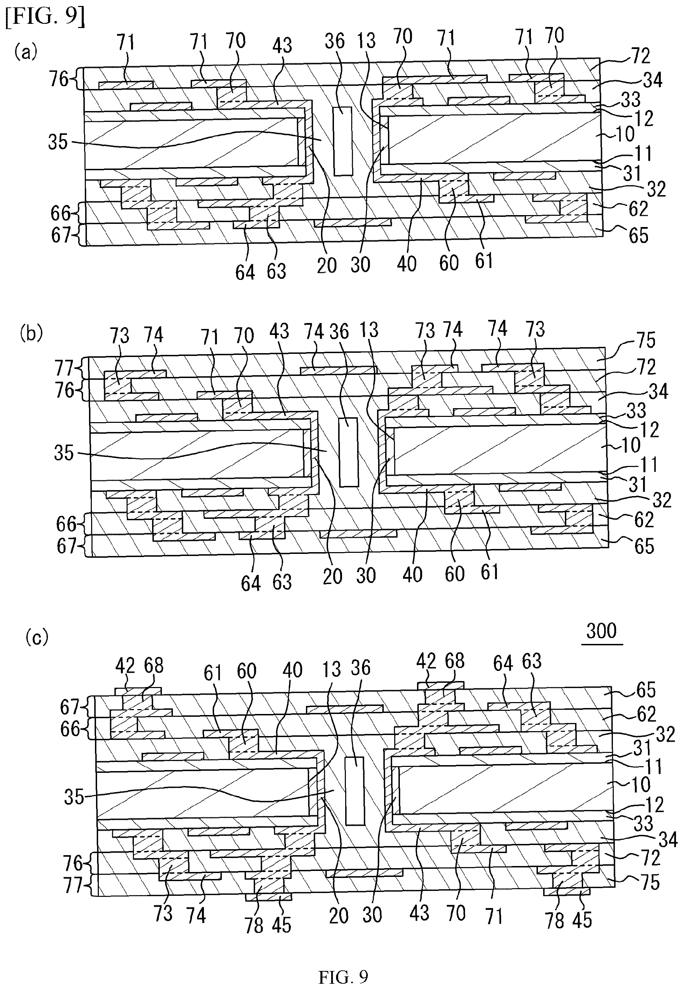

As illustrated in FIG. 9(a), the substrate 10 is turned upside down, openings are formed in the insulating film 34 to expose the second wiring patterns 43, and through wirings 70 are formed so as to fill the openings. Thereafter, a conductive film is formed on the second surface 12 of the substrate 10, and then the conductive film is patterned to form one or a plurality of fifth wiring patterns 71. The fifth wiring pattern 71 is formed of, for example, the same material as the third wiring pattern 61. Next, an insulating film 72 which is a silicon oxide film is formed on the second surface 12 of the substrate 10. The insulating film 72 is formed on the insulating film 34 so as to cover the one or the plurality of the fifth wiring patterns 71. Thus, a wiring layer 76 including the one or the plurality of fifth wiring patterns 71 and the insulating film 72 is formed. The thickness of the one or the plurality of fifth wiring patterns 71 included in the wiring layer 76 and the total area of the surfaces of the one or the plurality of fifth wiring patterns 71 on the side opposite to the substrate 10 are made to be the same as the thickness of the one or the plurality of third wiring patterns 61 included in the wiring layer 66 and the total area of the surfaces of the one or the plurality of third wiring patterns 61 on the side opposite to the substrate 10.

As illustrated in FIG. 9(b), openings through which the fifth wiring patterns 71 are exposed are formed in the insulating film 72, and through wirings 73 are formed so as to fill the openings. One or a plurality of sixth wiring patterns 74 connected to the through wirings 73 are formed on the insulating film 72. The sixth wiring pattern 74 is formed of, for example, the same material as the fourth wiring pattern 64. An insulating film 75 is formed on the insulating film 72 so as to cover the one or the plurality of sixth wiring patterns 74. Thus, a wiring layer 77 including the one or the plurality of sixth wiring patterns 74 and the insulating film 75 is formed. The thickness of the one or the plurality of sixth wiring patterns 74 included in the wiring layer 77 and the total area of the surfaces of the one or the plurality of sixth wiring patterns 74 on the side opposite to the substrate 10 are made to be the same as the thickness of the one or the plurality of fourth wiring patterns 64 included in the wiring layer 67 and the total area of the surface of the one or the plurality of fourth wiring patterns 64 on the side opposite to the substrate 10.

As illustrated in FIG. 9(c), the through wirings 68 connected to the fourth wiring patterns 64 are formed in the insulating film 65 by the same method as illustrated in FIGs. 5(b) and 5(c), and the first terminal electrodes 42 connected to the through wirings 68 are formed on the insulating film 65. Through wirings 78 connected to the sixth wiring patterns 74 are formed in the insulating film 75, and second terminal electrodes 45 connected to the through wirings 78 are formed on the insulating film 75. Thus, a device 300 according to the third embodiment is formed.

According to the third embodiment, as illustrated in FIGs. 8(b) and 8(c), the one or the plurality of wiring layers 66 and 67 (first wiring layers) are formed on the side opposite to the substrate 10 against the one or the plurality of first wiring patterns 40. As illustrated in FIGs. 9(a) and 9(b), the one or the plurality of wiring layers 76 and 77 (second wiring layers) having the same number of layers as the one or the plurality of wiring layers 66 and 67 are formed on the side opposite to the substrate 10 against the one or the plurality of second wiring patterns 43. This makes it possible to make the number of wiring layers formed on the first surface 11 of the substrate 10 equal to the number of wiring layers formed on the second surface 12, thereby reducing the warpage of the substrate 10.

In addition, in the third embodiment, the one or the plurality of wiring layers 66, 67 and the one or the plurality of wiring layers 76, 77 are formed so that the thickness of the wiring pattern and the total area of the surfaces on the side opposite to the substrate 10 in the layers having the same number of layers from the substrate 10 are the same as each other. That is, the one or the plurality of third wiring patterns 61 in the wiring layer 66 and the one or the plurality of fifth wiring patterns 71 in the wiring layer 76, which are the same number of layers from the substrate 10, are formed so that the thickness and the total area on the side opposite to the substrate 10 are the same as each other. Similarly, the one or the plurality of fourth wiring patterns 64 in the wiring layer 67 and the one or the plurality of sixth wiring patterns 74 in the wiring layer 77, which are the same number of layers from the substrate 10, are formed so that the thickness and the total area on the side opposite to the substrate 10 are the same as each other. This can reduce the warpage of the substrate 10. The fact that the thicknesses are the same and the total areas are the same are not limited to the case where the thicknesses are completely the same as each other and the total areas are completely the same as each other, but a difference to the extent of a manufacturing error is allowed. For example, the thickness and the total area of the wiring pattern in one layer are 90% or more and 110% or less of the thickness and the total area of the wiring pattern in the other layer, and may be 95% or more and 105% or less of the thickness and the total area of the wiring pattern in the other layer.

### [Fourth Embodiment]

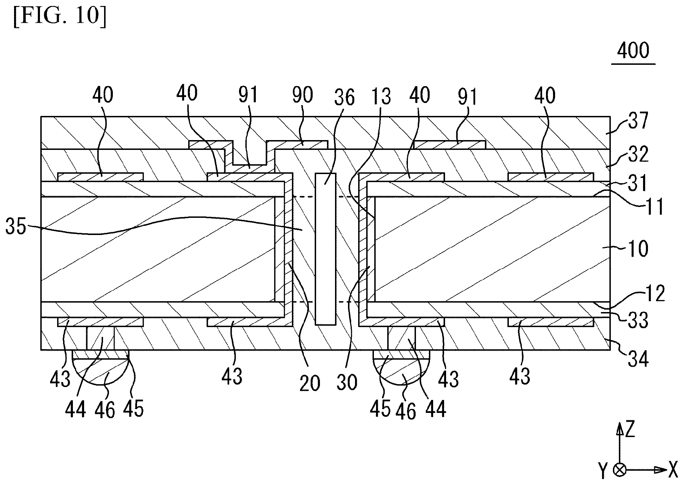

In the fourth embodiment, an example of a quantum bit device in which a quantum bit element is formed is illustrated. FIG. 10 is a cross-sectional view of a device according to a fourth embodiment. As illustrated in FIG. 10, in a device 400 according to the fourth embodiment, a quantum bit element 90 and one or a plurality of seventh wiring patterns 91 are provided on the insulating film 32. The quantum bit element 90 is connected to the seventh wiring pattern 91, and the through electrode 20 through the first wiring pattern 40. An insulating film 37 covering the quantum bit element 90 and the seventh wiring patterns 91 is provided on the insulating film 32. The insulating film 37 is, for example, a silicon oxide film, and has a thickness of, for example, 100 nm to 300 nm. The other configurations are the same as those of the first embodiment, and therefore, the description thereof is omitted.

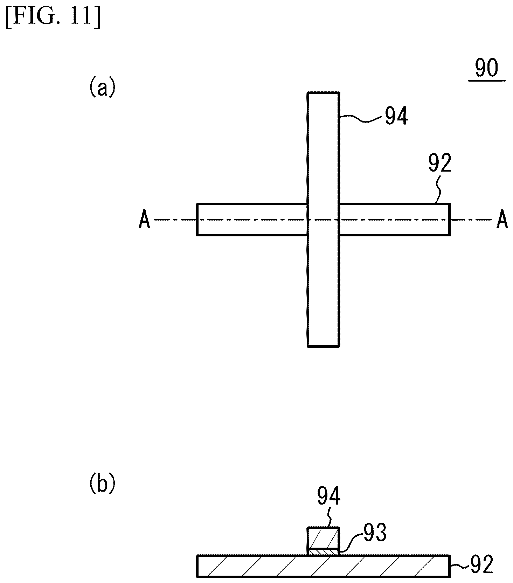

FIG. 11(a) is a plan view of a quantum bit element according to the fourth embodiment, and FIG. 11(b) is a cross-sectional view taken along a line A-A in FIG. 11(a). As illustrated in FIGs. 11(a) and 11(b), the quantum bit element 90 is a Josephson junction element having a lower superconducting film 92, an insulating film 93, and an upper superconducting film 94. The lower superconducting film 92 and the upper superconducting film 94 extend to intersect with each other. The insulating film 93 is provided between the lower superconducting film 92 and the upper superconducting film 94 at least at a location where the lower superconducting film 92 and the upper superconducting film 94 intersect each other. The lower superconducting film 92 and the upper superconducting film 94 are formed of a superconducting material such as aluminum. The insulating film 93 is formed of, for example, aluminum oxide.

### [Manufacturing Method]

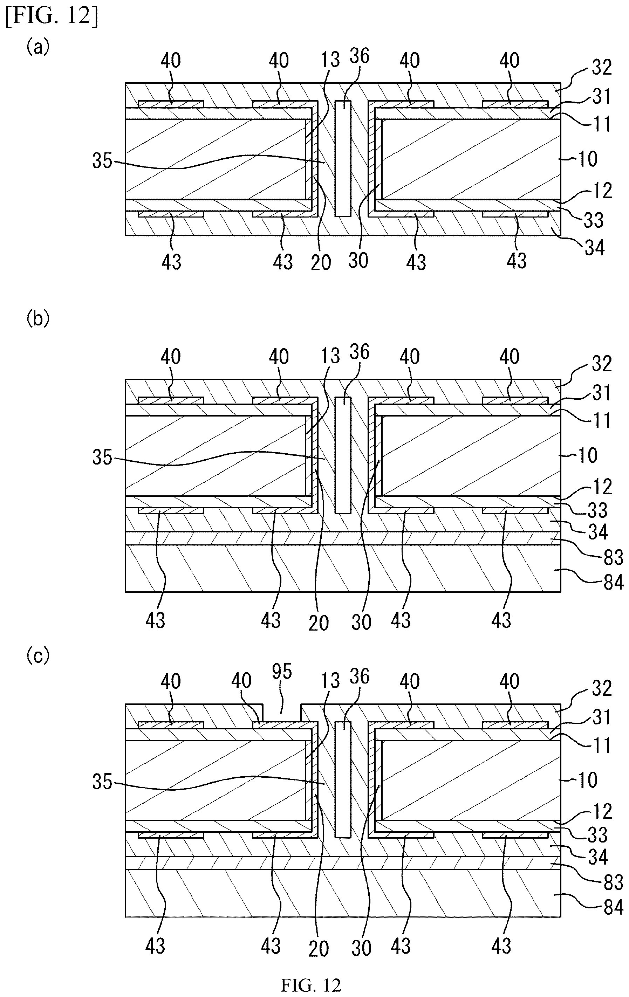

FIGs. 12(a) to 13(c) are cross-sectional views illustrating a method of manufacturing a device according to a fourth embodiment. First, the same steps as those in FIGs. 2(a) to 5(a) of the first embodiment are performed to obtain FIG. 12(a).

As illustrated in FIG. 12(b), the insulating film 34 is bonded to the supporting substrate 84 by the adhesive 83.

As illustrated in FIG. 12(c), a mask layer (not illustrated) formed on the insulating film 32 is used as a mask to form an opening 95 for exposing the first wiring pattern 40 in the insulating film 32 by the RIE using, for example, a fluorine-based gas.

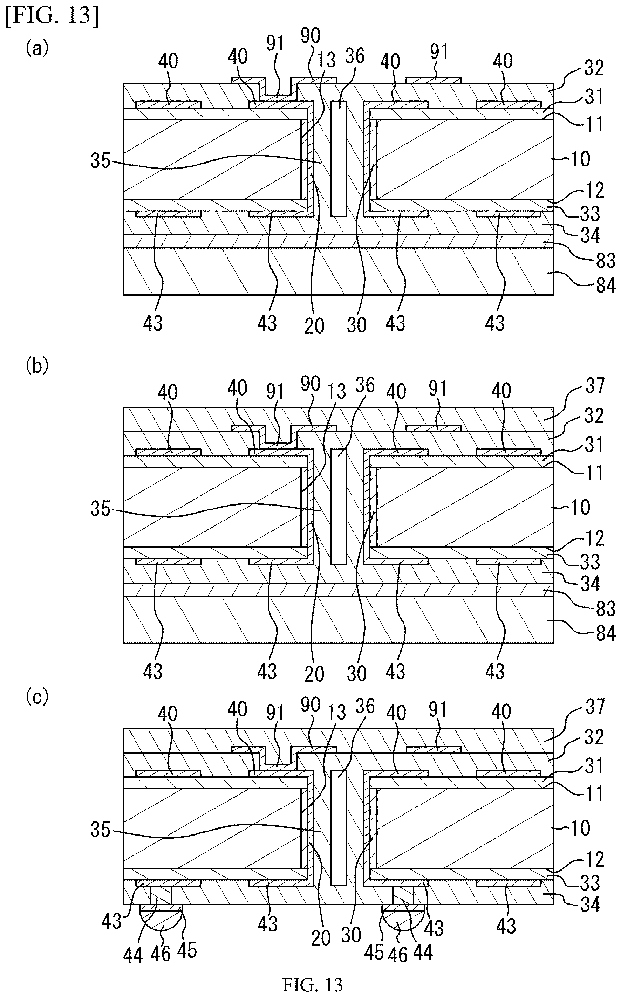

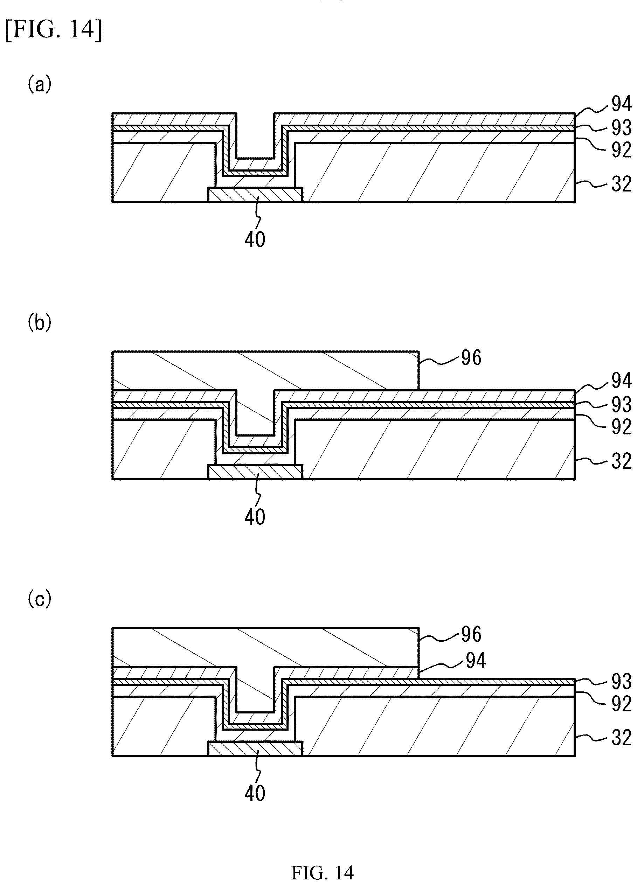

As illustrated in FIG. 13(a), the quantum bit element 90 and the one or the plurality of seventh wiring patterns 91 are formed on the insulating film 32. The quantum bit element 90 is connected to the first wiring pattern 40 through the seventh wiring pattern 91. Here, a method of forming the quantum bit element 90 and the seventh wiring pattern 91 will be described with reference to FIGs. 14(a) to 15(c).

FIGs. 14(a) to 15(c) are cross-sectional views illustrating a method of manufacturing the quantum bit element and the seventh wiring pattern according to the fourth embodiment. As illustrated in FIG. 14(a), the lower superconducting film 92 is formed on the insulating film 32 by, for example, a vapor deposition method. The insulating film 93 is formed on the lower superconducting film 92 by, for example, the ALD method. The upper superconducting film 94 is formed on the insulating film 93 by, for example, the vapor deposition method.

As illustrated in FIG. 14(b), a mask layer 96 which is, for example, a silicon oxide film is formed on the upper superconducting film 94 by, for example, the CVD method. Thereafter, the mask layer 96 is patterned.

As illustrated in FIG. 14(c), the mask layer 96 is used as a mask to etch the upper superconducting film 94 by the RIE using, for example, a chlorine-based gas.

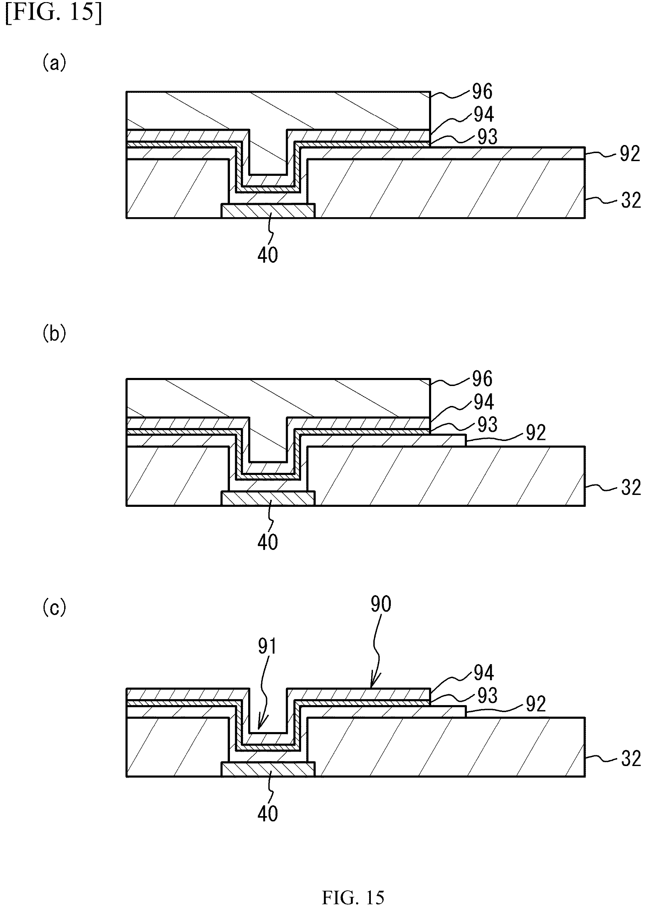

As illustrated in FIG. 15(a), the mask layer 96 is used as a mask to etch the insulating film 93 using, for example, a milling method.

As illustrated in FIG. 15(b), the mask layer 96 is used as a mask to etch the lower superconducting film 92 by the RIE using, for example, a chlorine-based gas.

As illustrated in FIG. 15(c), the mask layer 96 is removed. Thus, the quantum bit element 90 is formed by the lower superconducting film 92, the insulating film 93, and the upper superconducting film 94. The seventh wiring pattern 91 is also formed by the lower superconducting film 92, the insulating film 93, and the upper superconducting film 94. The quantum bit element 90 is connected to the first wiring pattern 40 through the seventh wiring pattern 91.

As illustrated in FIG. 13(b), the insulating film 37 made of a silicon oxide film is formed on the insulating film 32 by, for example, the CVD method. The thickness of the insulating film 37 is, for example, 200 nm. The insulating film 37 is formed on the insulating film 32 so as to cover the quantum bit element 90 and the seventh wiring patterns 91.

As illustrated in FIG. 13(c), the supporting substrate 84 is peeled off. Thereafter, the through wirings 44 are formed in the insulating film 34 by the same method as that of FIG. 5(c) of the first embodiment, and the second terminal electrodes 45 are formed on the through wirings 44. The bump electrodes 46 are formed on the surfaces of the second terminal electrodes 45. Thus, the device 400 according to the fourth embodiment is formed.

### [Comparative Example]

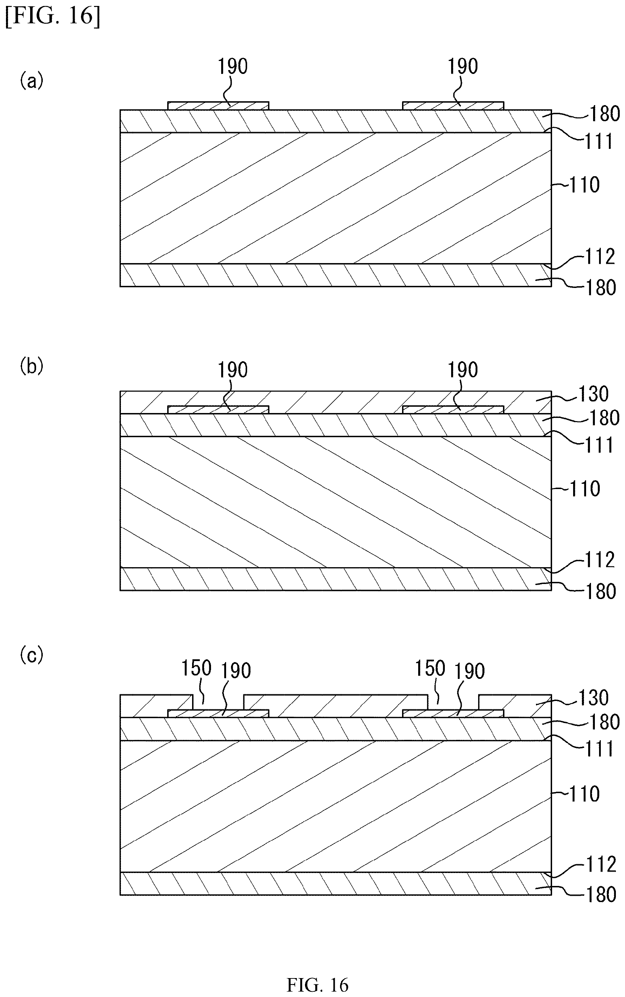

FIGs. 16(a) to 17(c) are cross-sectional views illustrating a method of manufacturing a device according to a comparative example. As illustrated in FIG. 16(a), a substrate 110 is heated in an oxidizing atmosphere to form thermal oxide films 180 on a first surface 111 and a second surface 112 of the substrate 110. Next, quantum bit elements 190 are formed on the thermal oxide film 180 formed on the first surface 111 of the substrate 110.

As illustrated in FIG. 16(b), an insulating film 130 which is a silicon oxide film is formed on the first surface 111 of the substrate 110 by, for example, the CVD method. The insulating film 130 is formed on the thermal oxide film 180 to cover the quantum bit elements 190.

As illustrated in FIG. 16(c), openings 150 through which the quantum bit elements 190 are exposed are formed in the insulating film 130 by the RIE using, for example, a fluorine-based gas.

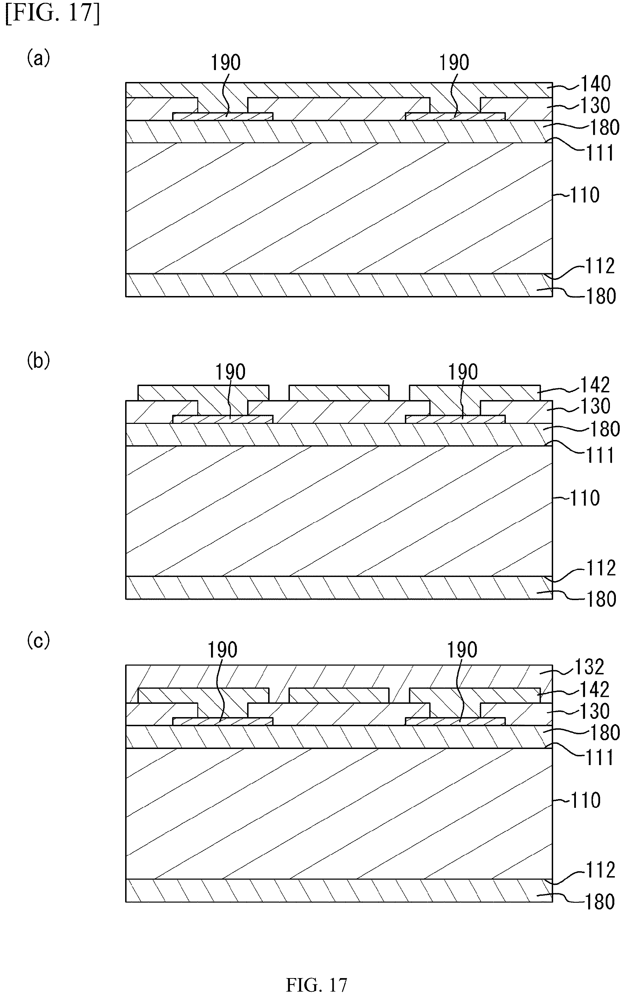

As illustrated in FIG. 17(a), a conductive film 140 is formed on the first surface 111 of the substrate 110 by, for example, the sputtering method. The conductive film 140 is formed by also being embedded into the openings 150 formed in the insulating film 130. The conductive film 140 is formed of, for example, titanium nitride.

As illustrated in FIG. 17(b), the conductive film 140 is patterned by the RIE using, for example, a chlorine-based gas to form one or a plurality of wiring patterns 142. A part of the one or the plurality of wiring patterns 142 is connected to the quantum bit elements 190.

As illustrated in FIG. 17(c), an insulating film 132 which is a silicon oxide film is formed on the first surface 111 of the substrate 110 by, for example, the CVD method. The insulating film 132 is formed on the insulating film 130 so as to cover the wiring patterns 142.

In the case of forming a multilayer wiring structure in which a plurality of wiring patterns are laminated, the steps illustrated in FIGs. 16(c) to 17(c) are repeated.

According to the comparative example, as illustrated in FIGs. 16(a) to 17(c), after the quantum bit element 190 is formed, the insulating film 130 is formed and processed, the conductive film 140 is formed and processed, and the insulating film 132 is formed. The insulating films 130 and 132 are formed by, for example, the CVD method. In the film formation by the CVD method, the temperature of the substrate 110 becomes several hundred degrees centigrade, which may damage the quantum bit element 190. The conductive film 140 is formed by, for example, the sputtering method, and the insulating film 130 and the conductive film 140 are processed by the RIE. In the sputtering method and the RIE, since the insulating film 130 and the conductive film 140 are irradiated with charged particles, which may also damage the qubit element 190. From these facts, it is considered that the characteristics of the quantum bit element 190 deteriorate.

On the other hand, according to the fourth embodiment, after the one or the plurality of first wiring patterns 40 and the one or the plurality of second wiring patterns 43 are formed as illustrated in FIG. 12(a), the quantum bit element 90 connected to the one or the plurality of first wiring patterns 40 is formed as illustrated in FIG. 13(a). In this way, by forming the quantum bit element 90 after the first wiring patterns 40 and the second wiring patterns 43, damage to the quantum bit element 90 can be reduced. Therefore, the characteristic deterioration of the quantum bit element 90 can be suppressed, and the operation of the quantum bit element 90 can be stabilized.

In the fourth embodiment, the case where the quantum bit element 90 is formed on the first surface 11 of the substrate 10 is described as an example, but the quantum bit element 90 may be formed on the second surface 12. In the fourth embodiment, the wiring layer formed closer to the substrate 10 than the quantum bit element 90 may have a multilayer wiring structure.

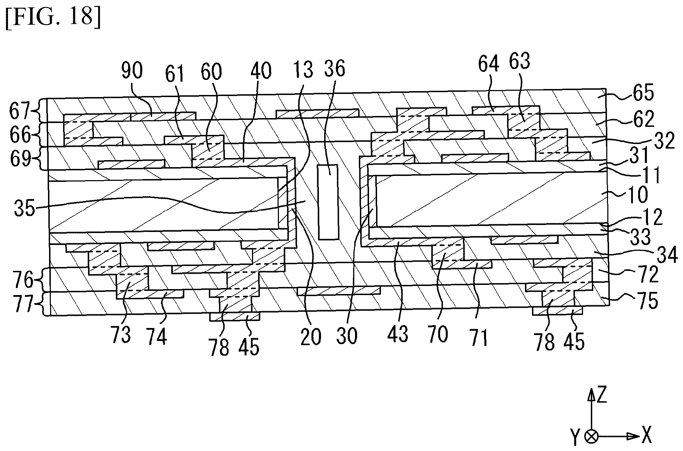

FIG. 18 is a cross-sectional view of a case where a plurality of wiring layers are laminated closer to the substrate than the quantum bit element. As illustrated in FIG. 18, it is preferable that the quantum bit element 90 is formed in the wiring layer 67 which is farthest from the substrate 10 in the plurality of wiring layers 66, 67, and 69 formed on the first surface 11 of the substrate 10. That is, the quantum bit element 90 is preferably formed after the wiring patterns in all of the wiring layers 66, 67, and 69 formed on the first surface 11 side of the substrate 10. By forming the quantum bit element 90 after all the wiring patterns, damage to the quantum bit element 90 can be reduced, and the temperature of the annealing process in the wiring process can be increased.

### [Fifth Embodiment]

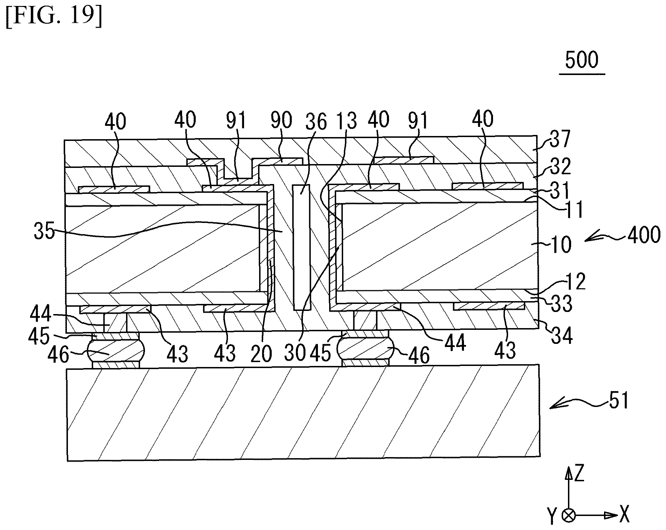

FIG. 19 is a cross-sectional view showing a method of manufacturing a device according to a fifth embodiment. As illustrated in FIG. 19, the circuit chip 51 is flip-chip mounted on the second surface 12 of the substrate 10 constituting the device 400. The circuit chip 51 is bonded to the second terminal electrodes 45 by the bump electrodes 46. Thus, a device 500 according to the fifth embodiment is formed.

In addition to the second terminal electrodes 45 being formed on the second surface 12 of the substrate 10 in the device 400, the first terminal electrodes 42 may be formed on the first surface 11. In this case, the quantum bit chip 50 may be flip-chip mounted on the first terminal electrodes 42. Alternatively, the circuit chip 51 may be flip-chip mounted on the first terminal electrodes 42, and the quantum bit chip 50 may be flip-chip mounted on the second terminal electrodes 45.

Although the embodiments of the present invention have been described in detail, the present invention is not limited to the specific embodiments, and various modifications and changes can be made within the scope of the gist of the present invention as described in the claims.

### [Reference Signs List]

10... substrate, 11... first surface, 12... second surface, 13... through hole, 20... through electrode, 30, 31, 32, 33, 34, 35... insulating film, 36... cavity, 37... insulating film, 40... first wiring pattern, 41... through wiring, 42... first terminal electrode, 43... second wiring pattern, 44... through wiring, 45... second terminal electrode, 46... bump electrode, 48, 49... surface, 50... quantum bit chip, 51... circuit chip, 52... bump electrode, 60... through wiring, 61... third wiring pattern, 62... insulating film, 63... through wiring, 64... fourth wiring pattern, 65... insulating film, 66, 67... wiring layer, 68... through wiring, 70... through wiring, 71... fifth wiring pattern, 72... insulating film, 73... through wiring, 74... sixth wiring pattern, 75... insulating film, 76, 77... wiring layer, 78... through wiring, 80... thermal oxide film, 81... resist film, 82... recess, 83... adhesive, 84... supporting substrate, 85... conductive film, 86... insulating film, 87... film formation chamber, 88... heating unit, 90... quantum bit element, 91... seventh wiring pattern, 92... lower superconducting film, 93... insulating film, 94... upper superconducting film, 95... opening, 96... mask layer, 100... device, 110... substrate, 111... first surface, 112... second surface, 130, 132... insulating film, 140... conductive film, 142... wiring pattern, 155... opening, 180... thermal oxide film, 190... quantum bit element, 200, 300, 400, 500... device

## Claims

1. A method of manufacturing a device comprising:
a step of forming a conductive film made of a superconducting material on a substrate having a first surface, a second surface opposite to the first surface, and a through hole penetrating between the first surface and the second surface, the conductive film extending from the first surface to the second surface via a side surface of the through hole;
a step of patterning the conductive film on the first surface to form a first wiring pattern;
a step of patterning the conductive film on the second surface to form a second wiring pattern; and
a step of forming a quantum bit element connected to the first wiring pattern.

2. The method of manufacturing the device according to claim 1, wherein
the step of forming the conductive film forms the conductive film by an atomic layer deposition method.

3. The method of manufacturing the device according to claim 1 or 2, wherein
the step of patterning the conductive film on the first surface and the step of patterning the conductive film on the second surface form the first wiring pattern and the second wiring pattern, respectively, so that a total area of a surface of the first wiring pattern opposite to the substrate is the same as a total area of a surface of the second wiring pattern opposite to the substrate.

4. The method of manufacturing the device according to claim 1 or 2, further comprising:
a step of forming one or a plurality of first wiring layers on a side opposite to the substrate against the first wiring pattern; and
a step of forming one or a plurality of second wiring layers on a side opposite to the substrate against the second wiring pattern, a number of the one or the second wiring layers being the same as that of the one or the plurality of first wiring layers.

5. The method of manufacturing the device according to claim 4, wherein
the step of forming the one or the plurality of first wiring layers and the step of forming the one or the plurality of second wiring layers form the one or the plurality of first wiring layers and the one or the plurality of second wiring layers, repscetively, so that a thickness of a wiring pattern and a total area of a surface on a side opposite to the substrate in layers having the same number of layers from the substrate are the same as each other.

6. The method of manufacturing the device according to claim 1 or 2, further comprising:
a step of forming a first terminal electrode for external connection on the first surface, the first terminal electrode being connected to at least one of the first wiring pattern; and
a step of forming a second terminal electrode for external connection on the second surface, the second terminal electrode being connected to at least one of the second wiring pattern.

7. The method of manufacturing the device according to claim 6, further comprising:
a step of mounting a quantum bit chip on one of the first surface and the second surface; and
a step of mounting a circuit chip on another of the first surface and the second surface.

8. A device comprising:
a substrate having a first surface, a second surface opposite to the first surface, and a through hole penetrating between the first surface and the second surface;
a through electrode made of a superconducting material extending from the first surface to the second surface via a side surface of the through hole;
a first wiring pattern provided on the first surface and formed of the same material as the through electrode;
a second wiring pattern provided on the second surface and formed of the same material as the through electrode; and
a quantum bit element connected to the first wiring pattern.
